(19) Europäisches Patentamt / European Patent Office / Office européen des brevets

(11) **EP 3 114 493 B1**

(12) **FASCICULE DE BREVET EUROPEEN**

(45) Date de publication et mention
de la délivrance du brevet:
**03.05.2023   Bulletin 2023/18**

(21) Numéro de dépôt: **15713992.4**

(22) Date de dépôt: **09.03.2015**

(51) Classification Internationale des Brevets (IPC):
**B60L 3/00** *(2019.01)*       **B60L 3/12** *(2006.01)*
**B60L 58/13** *(2019.01)*      **B60L 58/16** *(2019.01)*
**B60L 58/22** *(2019.01)*      **G01R 31/392** *(2019.01)*
**G01R 31/396** *(2019.01)*    **G01R 31/367** *(2019.01)*
**H02J 7/00** *(2006.01)*

(52) Classification Coopérative des Brevets (CPC):
**G01R 31/367; B60L 3/0046; B60L 3/12;
B60L 58/13; B60L 58/16; B60L 58/22;
G01R 31/392; G01R 31/396;** B60L 2240/545;
B60L 2240/547; B60L 2240/549; B60L 2260/44;
H02J 7/0013; H02J 7/0048; Y02T 10/70

(86) Numéro de dépôt international:
**PCT/FR2015/050566**

(87) Numéro de publication internationale:
**WO 2015/132544 (11.09.2015 Gazette 2015/36)**

(54) **MÉTHODE D'ESTIMATION D'UN ÉTAT DE CHARGE D'UNE BATTERIE COMPORTANT PLUSIEURS CELLULES PRÉSENTANT UNE PLAGE D'UTILISATION D'ÉTAT DE CHARGE VARIABLE**

VERFAHREN ZUR BEURTEILUNG EINES ZUSTANDS EINER BATTERIE MIT EINER VIELZAHL VON ZELLEN MIT EINEM VARIABLEN VERWENDUNGSBEREICH AN LADEZUSTÄNDEN

METHOD FOR ASSESSING A STATE OF CHARGE OF A BATTERY COMPRISING A PLURALITY OF CELLS HAVING A VARIABLE RANGE OF USE OF STATE OF CHARGE

(84) Etats contractants désignés:
**AL AT BE BG CH CY CZ DE DK EE ES FI FR GB
GR HR HU IE IS IT LI LT LU LV MC MK MT NL NO
PL PT RO RS SE SI SK SM TR**

(30) Priorité:  **07.03.2014   FR 1451892**

(43) Date de publication de la demande:
**11.01.2017   Bulletin 2017/02**

(73) Titulaire: **Renault s.a.s
92100 Boulogne Billancourt (FR)**

(72) Inventeur: **LUCEA, Marc
F-78000 Versailles (FR)**

(74) Mandataire: **Renault Group
Renault s.a.s.
API : TCR GRA 2 36
1, Avenue du Golf
78084 Guyancourt Cedex (FR)**

(56) Documents cités:
**EP-A1- 2 474 833          EP-A1- 2 572 951
WO-A1-2005/010539      WO-A1-2012/169009
WO-A1-2013/167833      WO-A2-2011/079977
DE-A1-102009 042 194    FR-A1- 2 982 676
JP-A- 2012 173 250          US-A1- 2013 027 048
US-A1- 2013 154 574**

**Description**

Domaine de l'invention

L'invention concerne une méthode et un système pour estimer l'état de charge d'une batterie comportant plusieurs cellules électrochimiques connectées en série.

Cette invention peut s'appliquer quel que soit le type de batterie et s'étend de manière non exclusive aux véhicules. En particulier, l'invention trouve une application particulière dans des domaines industriels tels que l'automobile et les ordinateurs ; elle est valable pour tout système embarqué ou débarqué.

Etat de la technique

Dans le domaine non limitatif des véhicules électriques et hybrides, l'un des principaux enjeux des systèmes de gestion des batteries de traction est l'estimation de l'état de charge de la batterie, encore appelé SOC (initiales anglo-saxonnes signifiant « State of Charge »). Cette information est affichée au niveau du tableau de bord, sous forme d'une « jauge batterie », et permet au conducteur de connaître l'autonomie kilométrique restante. L'autonomie d'un véhicule électrique étant très inférieure à celle d'un véhicule thermique, il est important de rassurer le conducteur en lui fournissant l'information la plus fiable possible. Des erreurs d'estimation de la jauge batterie peuvent en effet amener le conducteur à se retrouver dans des situations désagréables (panne sèche), voire dangereuses (manque de puissance pendant un dépassement).

Aujourd'hui, l'état de charge $SOC_{pack}$ d'une batterie comportant N cellules électrochimiques $C_i$ (où i entier compris entre 1 et N) connectées en série est estimé classiquement à partir de mesures relatives à la batterie considérée dans sa globalité. Ainsi, un premier équipement mesure la tension totale $U_{BAT}$ délivrée par la batterie, mesurée aux bornes de l'ensemble des cellules en série, et des capteurs de courant et de température mesurent respectivement le courant $I_{BAT}$ traversant la batterie et la température $T_{BAT}$ de la batterie. A partir de ces trois mesures, un bloc logiciel calcule une estimation de l'état de charge $SOC_{pack}$ en utilisant une méthode classique telle qu'une méthode ampère-heure-métrique, ou encore une modélisation du type filtrage de Kalman. Une telle estimation basée sur des mesures globales correspond ainsi grossièrement à une moyenne de l'état de charge des cellules.

Or, les cellules électrochimiques constitutives de la batterie ont, de par leur construction, des caractéristiques différentes les unes des autres en termes de dispersion de leur capacité et de leur résistance interne, et subissent par ailleurs des variations de température différentes dues à leur emplacement dans la batterie. En conséquence, ces cellules ont forcément des états de charge différents les uns des autres, c'est pourquoi on dit que la batterie est en déséquilibre. Quand cela a lieu, la plage d'utilisation de la batterie est imposée par la cellule la plus chargée et par la cellule la moins chargée. Dans ce cas, l'estimation basée sur des mesures globales est fausse.

D'autres dispositifs d'estimation envisagés préconisent d'estimer l'état de charge de chaque cellule individuellement, pour en déduire une valeur d'état de charge pour la batterie, en prenant en compte le déséquilibre des cellules. Un tel dispositif comporte idéalement un premier équipement mesurant simultanément les tensions $U_1$ à $U_N$ aux bornes de chaque cellule $C_i$ composant la batterie, un capteur de courant mesurant respectivement le courant $I_{BAT}$ traversant les N cellules de la batterie et des capteurs de température fournissant la température $T_i$ de chaque cellule Ci composant la batterie. A partir de chaque mesure $U_i$, Ti et $I_{BAT}$, N blocs logiciels calculent une estimation de l'état de charge $SOC_i$ de chaque cellule Ci, en utilisant une méthode classique telle qu'une méthode ampère-heure-métrique, ou encore une modélisation du type filtrage de Kalman. L'état de charge $SOC_{pack}$ de la batterie est alors estimé par un module de calcul à partir des N états de charge délivrés $SOC_i$ par les blocs logiciels. Ces dispositifs sont certes plus précis, mais aussi plus chers et plus complexes d'un point de vue logiciel. Ils nécessitent des mesures de tension aux bornes de chacune des cellules composant la batterie et des modèles sophistiqués pour décrire le comportement de chaque cellule (filtre de Kalman notamment). Dans le cas d'une batterie haute tension, telles que celles utilisées pour un véhicule électrique, le grand nombre de cellules élémentaires (96 bi-cellules dans les batteries actuelles) rend le coût du dispositif important.

Enfin, dans le domaine, est connue une méthode d'estimation d'un état de charge d'une batterie dans laquelle, en s'appuyant sur des estimations portant sur un état de charge maximale $SOC_{max}$ de la cellule la plus chargée et sur un état de charge minimale $SOC_{min}$ de la cellule la moins chargée, il est possible de reconstruire l'état de charge $SOC_{pack}$ de la batterie ; la valeur de l'état de charge $SOC_{pack}$ tend vers 0 quand l'état de charge minimale $SOC_{min}$ tend vers 0, et vers 1 quand l'état de charge minimale $SOC_{max}$ tend vers 1. Une telle méthode est divulguée par la demanderesse dans FR2990516. Il a été constaté que cette méthode n'était pas optimale, car elle utilise une valeur minimale d'état de charge admissible $BSOC_{min}$ et une valeur maximale d'état de charge admissible $BSOC_{max}$ qui sont fixes, ce qui empêche de maintenir à une valeur constante la quantité maximale d'énergie emmagasinée dans la batterie, notamment quel que soit l'état de vieillissement des cellules. Pour l'utilisateur, la variabilité de la quantité maximale d'énergie emmagasinée est préjudiciable car elle peut causer des situations désagréables telles que la panne sèche ou le manque de puissance lors d'un dépassement: ces situations seraient dues à une mauvaise estimation de l'état de charge de la batterie.

Le document JP 2012 173250 A divulgue une méthode présentant des inconvénients similaires de manque de fiabilité. Les documents EP 2 473 833 A1, WO 2013/167833 A1, US 2913/027048 A1, WO 2011/079977 A2, WO 2005/0105339 A1, FR 2 982 676 A1, US2013/154574 A1, DE 10 2009 0421994 A1, EP 2 572 951 A1 et WO 2012/169009 A1 également concernent également différents aspects concernant l'estimation de l'état de charge d'une batterie comprenant une pluralité de cellules de batterie.

Objet de l'invention

Dans ce contexte, l'invention a pour but de pallier les inconvénients de l'art antérieur en proposant, à moindre coût, une méthode d'estimation précise d'un état charge d'une batterie prenant en compte le déséquilibre des cellules. En particulier, il s'agit d'offrir une méthode dans laquelle la quantité maximale d'énergie emmagasinée est globalement constante afin d'éviter que l'utilisateur ne se retrouve dans une situation inconfortable l'empêchant d'estimer si l'autonomie restante du véhicule est suffisante pour terminer son trajet. Un autre objectif ici visé est d'ajuster la plage d'utilisation d'état charge de chaque cellule en prenant en compte l'état de santé de la cellule, notamment son état de vieillissement. Enfin, la présente invention vise à proposer une méthode d'estimation d'un état de charge d'une batterie se basant sur des estimations d'état de charge des cellules ou de la batterie afin de limiter le nombre de calculateurs nécessaires pour mettre en oeuvre cette méthode.

La solution proposée est la méthode d'estimation d'un état de charge d'une batterie comportant plusieurs cellules électrochimiques connectées en série définie par la revendication 1.

Cette solution permet de pallier aux problèmes précités.

Plus précisément, l'ajustement de la valeur minimale d'état de charge admissible et de ladite valeur maximale d'état de charge admissible de chaque cellule en fonction d'une grandeur physique représentative d'un état de santé de la cellule permet de prendre en compte l'état de santé de chaque cellule afin de choisir judicieusement une plage d'utilisation d'état de charge minimisant les incertitudes d'estimation de l'état de charge de la batterie comportant lesdites cellules. Cette approche permet d'estimer de manière plus fiable l'autonomie restante de la batterie qui est classiquement appliqué à un véhicule électrique ou hybride. La dépendance des plages d'utilisation d'état de charge des cellules à leurs états de santé respectifs permet de conserver une quantité maximale d'énergie emmagasinée de la batterie sensiblement constante. Par ailleurs, cette méthode permet d'ajuster les états de charge minimale et maximale de la batterie en fonction de l'état de santé de chaque cellule et cela en utilisant un minimum d'équipements. A titre d'exemple, un capteur de courant placé en série avec les cellules, un capteur pour mesurer la température de la batterie, un composant électronique apte à mesurer uniquement les tension de cellule minimale et tension de cellule maximale et un système de gestion de l'état de charge de la batterie recueillant la mesure de courant réalisée par le capteur de courant, la mesure de température réalisée par le capteur de température et la mesure de la tension de cellule minimale et de la tension de cellule maximale, permettent d'arriver à ce résultat avec peu de ressources calculatoires.

Dans un mode de réalisation, lorsque l'état de charge maximale de la cellule ayant la tension de cellule maximale est inférieur ou égal à la valeur maximale d'état de charge admissible de ladite cellule et que l'état de charge minimale de la cellule ayant la tension de cellule minimale est supérieur ou égal à la valeur minimale d'état de charge admissible de ladite cellule, la méthode d'estimation comprend une étape incluant d'estimer l'état de charge ($SOC_{pack}$) de la batterie, à un instant k donné, au moyen de la relation :

$$SOC_{pack}(k) = \frac{SOC_{min}(k) - BSOC_{min}(k)}{(BSOC_{max}(k) - SOC_{max}(k)) + (SOC_{min}(k) - BSOC_{min}(k))} \times (BSOC_{max}(k) - BSOC_{min}(k)) + BSOC_{min}(k)$$

Dans un mode de réalisation de l'invention, lorsque l'état de charge maximale de la cellule ayant la tension de cellule maximale est strictement supérieur à la valeur maximale d'état de charge admissible de ladite cellule et que l'état de charge minimale de la cellule ayant la tension de cellule minimale est strictement inférieur à la valeur minimale d'état de charge admissible de ladite cellule, la méthode comprend une étape incluant d'attribuer la valeur « indisponible » à l'état de charge de la batterie.

Dans un mode de réalisation, ladite au moins une grandeur physique représentative d'un état de santé de la cellule est une tension mesurée aux bornes de cette cellule et/ou un courant traversant la cellule et/ou une température liée à la cellule.

Dans un mode de réalisation, la correspondance entre les valeurs minimale et maximale d'état de charge admissible et ladite au moins une grandeur physique représentative de l'état de santé de la cellule est prédéterminée, préférentiellement dans une table de valeur.

Dans un mode de réalisaiton :

- la plage d'utilisation définie entre la valeur minimale d'état de charge admissible et la valeur maximale d'état de charge admissible est agencé de sorte à s'élargir en fonction de l'état de santé de la cellule et de l'avancement de son vieillissement, et/ou,
- ladite plage d'utilisation est agencé de sorte à être bornée lorsque la température de la batterie est relativement basse et inférieure à un seuil de température prédéterminée.

Il est également visé un deuxième objet de l'invention dans lequel un système d'estimation d'un état de charge d'une batterie comportant plusieurs cellules électrochimiques connectées en est défini selon la revendication 7.

Dans un mode de réalisation, le système comprend un premier module apte à délivrer directement à l'unité de contrôle électronique uniquement la tension de cellule minimale et la tension de cellule maximale.

Suivant un troisième objet, est également visé un véhicule comprenant un système d'estimation selon l'un des modes de réalisation précités.

Brève description des figures

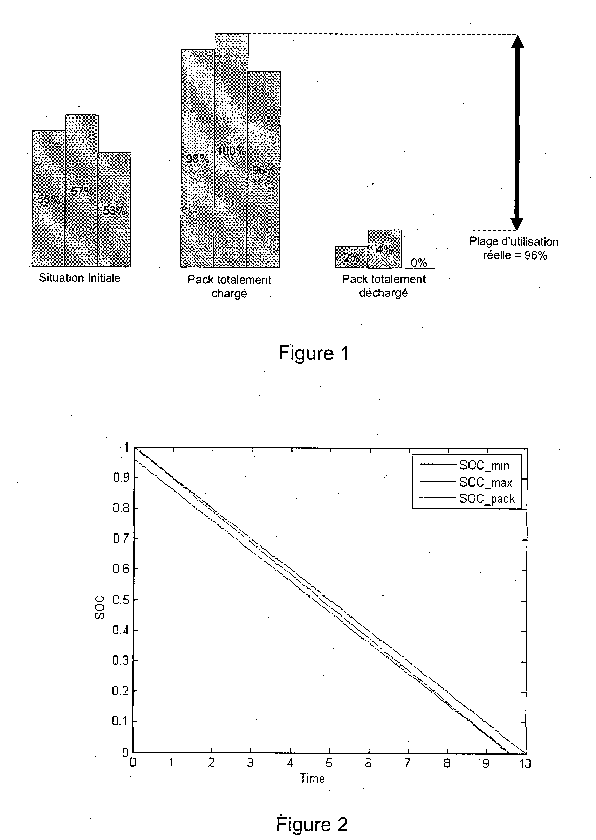

La figure 1 montre une méthode d'estimation d'un état de charge d'une batterie selon une technique antérieure dans laquelle, il y a une première situation où la batterie est dans un état initial, une deuxième situation où la batterie est totalement chargée et une troisième situation où la batterie est complètement déchargée. Est ici mis en évidence que la plage d'utilisation d'état de charge de la batterie est imposée par la cellule la plus chargée ou par la cellule la moins chargée, du fait des contraintes d'utilisation propres aux cellules qui doivent rester dans une plage de tension et d'état de charge données afin d'éviter tout risque d'incendie ou de dégradation prématurée. Pour chacune des situations montrées, la plage d'utilisation réelle est de 96 %.

La figure 2 montre un graphique représentant l'évolution de l'état de charge minimale (SOC_min) de la cellule ayant la tension de cellule minimale, de l'état de charge maximale (SOC_max) de la cellule ayant la tension de cellule maximale, et de l'état de charge (SOC_pack) de la batterie compris entre l'état de charge minimale et l'état de charge maximale, en fonction du temps, lors d'une phase de déstockage de la batterie, pour une plage d'utilisation d'état de charge des cellules comprise entre 0% et 100%, selon une méthode d'estimation antérieure.

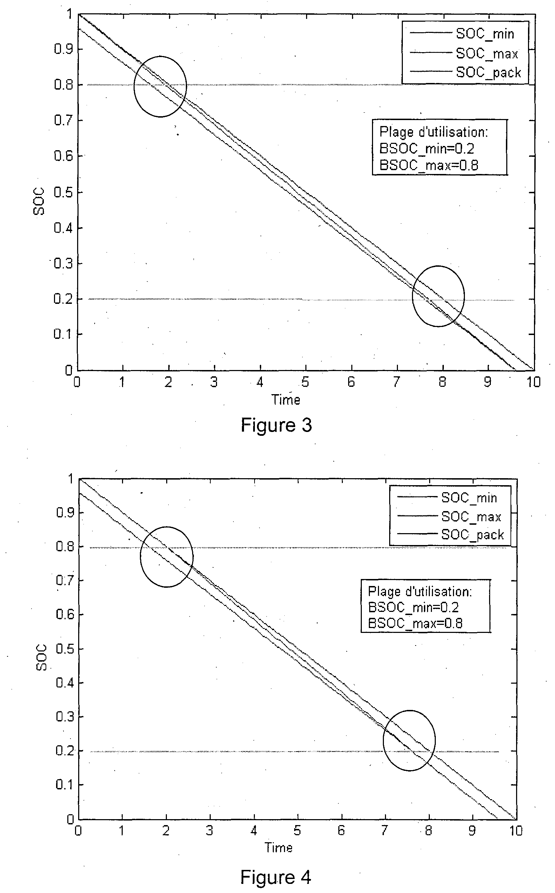

La figure 3 montre un graphique analogue au graphique de la figure 2, pour une plage d'utilisation d'état de charge des cellules comprise 20% et 80%, selon une méthode antérieure.

La figure 4 montre un graphique analogue au graphique de la figure 2, pour une même plage d'utilisation d'état de charge des cellules comprise entre 20% et 80%, pour une méthode selon l'invention. Les cercles présents sur la figure 2 mettent en évidence la correspondance entre les états de charge minimale et maximale des cellules et l'état de charge de la batterie, lorsque la batterie présente un état de charge de 20% ou 80%.

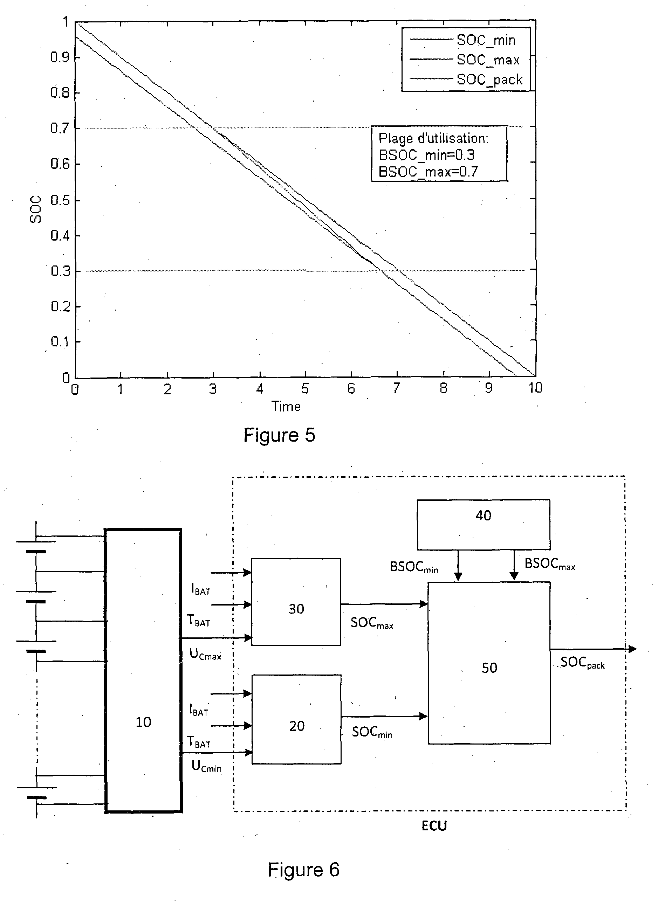

La figure 5 montre un graphique analogue au graphique de la figure 4, pour une plage d'utilisation d'état de charge des cellules comprise entre 30% et 70%, pour une méthode selon l'invention.

La figure 6 montre un schéma de principe du système comprenant des moyens de mise en oeuvre de la méthode selon l'invention.

Description d'exemples de réalisation de l'invention

Dans la suite, on considère une batterie comportant N cellules électrochimiques $C_1$ à $C_N$ connectées en série. En fonctionnement, les N cellules sont ainsi parcourues par un même courant $I_{BAT}$, et la tension $U_{BAT}$ aux bornes de la batterie correspond à chaque instant à la somme des N tensions $U_1$ à $U_N$ prises aux bornes des N cellules.

Selon l'invention, l'estimation de l'état de charge de la batterie est obtenue en s'intéressant à deux valeurs particulières des N tensions de cellule à un instant donné, l'une correspondant à la valeur minimale sur l'ensemble des tensions de cellule, appelée tension de cellule minimale, l'autre correspondant à la valeur maximale sur l'ensemble des tensions de cellule, appelée tension de cellule maximale, ces deux valeurs étant notées respectivement $U_{Cmin}$ et $U_{Cmax}$. Chacune des cellules $C_1$ à $C_N$ présente un état de charge SOC compris dans une plage d'utilisation d'état de charge comprenant une valeur minimale d'état de charge admissible $BSOC_{min}$ et une valeur maximale d'état de charge admissible $BSOC_{max;}$ le fonctionnement des cellules dans cette plage d'utilisation permet de les préserver d'éventuelles dégradations.

Il est en effet possible de définir une grandeur physique dont dépend directement ou indirectement l'état de charge $SOC_{pack}$ de la batterie, cette grandeur physique dépendant elle-même analytiquement directement ou indirectement de l'état de charge minimale $SOC_{min}$ et de l'état de charge maximale $SOC_{max}$ selon une équation incluant des éléments de pondération assurant que le poids associé à l'état de charge maximale $SOC_{max}$ augmente lorsque l'état de charge de la cellule associée augmente, et le poids associé à l'état de charge minimale $SOC_{min}$ augmente lorsque

l'état de charge de la cellule associée diminue. Il s'agit donc d'abord de déterminer à un instant donné la tension de cellule minimale $U_{Cmin}$ et la tension de cellule maximale $U_{Cmax}$ parmi les tensions aux bornes des cellules. Il convient ensuite de calculer un état de charge minimale $SOC_{min}$ de la cellule ayant la tension de cellule minimale $U_{Cmin}$ et un état de charge maximale $SOC_{max}$ de la cellule ayant la tension de cellule maximale $U_{Cmax}$, l'état de charge $SOC_{pack}$ de la batterie étant compris entre ledit état de charge minimale $SOC_{min}$ et ledit état de charge maximale $SOC_{max}$.

L'invention vise à assurer que le poids associé à l'état de charge maximale $SOC_{max}$ est maximum lorsque cet état de charge est au voisinage d'un seuil d'utilisation maximum prédéterminé correspondant à la valeur maximale d'état de charge admissible $BSOC_{max}$ de la cellule associée, et le poids associé à l'état de charge minimale $SOC_{min}$ est maximum lorsque cet état de charge $SOC_{min}$ est au voisinage d'un seuil d'utilisation minimum prédéterminé correspondant à la valeur minimale d'état de charge admissible $BSOC_{min}$ de la cellule associée. Entre les deux, la variation de la grandeur physique doit être continue et sans variations abruptes. Après l'étape de calcul permettant de déterminer l'état de charge minimale $SOC_{min}$ au moyen de la tension de cellule minimale $U_{Cmin}$ et l'état de charge maximale $SOC_{max}$ au moyen de la tension de cellule maximale $U_{Cmax}$, il est alors possible d'ajuster l'état de charge du pack batterie $SOC_{pack}$ en fonction des états de charge minimale et maximale $SOC_{min}$ et $SOC_{max}$, de ladite valeur minimale d'état de charge admissible $BSOC_{min}$ et de ladite valeur maximale d'état de charge admissible $BSOC_{max}$.

Selon l'invention, ladite valeur minimale d'état de charge admissible $BSOC_{min}$ et ladite valeur maximale d'état de charge admissible $BSOC_{max}$ de chaque cellule sont variables. Plus précisément ces valeurs $BSOC_{min}$ et $BSOC_{max}$ sont ajustées en fonction d'au moins une grandeur physique représentative d'un état de santé de la cellule et/ou en fonction de la température $T_{BAT}$ de la batterie. Cet état de santé de la cellule définit en fait l'état de vieillissement de la cellule.

Un schéma de principe d'un système d'estimation comprenant des moyens de mise en oeuvre de la méthode selon l'invention est représenté à la figure 6. Le système d'estimation comporte un premier module 10 relié à chaque borne des cellules $C_1...C_N$ composant la batterie, apte à délivrer les tensions de cellule minimale $U_{Cmin}$ et maximale $U_{Cmax}$. Le premier module 10 est de préférence un composant apte à réaliser la fonction MIN-MAX, c'est-à-dire à déterminer et délivrer directement à une unité de contrôle électronique ECU la tension de cellule minimale $U_{Cmin}$ et la tension de cellule maximale $U_{Cmax}$ sans qu'il soit nécessaire de mesurer les N tensions de cellule. Ce premier module 10 peut être un composant analogique ou logiciel. Le premier module 10 est préférentiellement capable d'identifier les deux cellules qui présentent les valeurs $U_{Cmin}$ et $U_{Cmax}$, permettant d'avoir une méthode toujours aussi précise mais nécessitant moins de puissance de calcul.

Le système comporte en outre un capteur de courant (non représenté) apte à fournir une mesure $I_{BAT}$ du courant de la batterie et un ou plusieurs capteurs de température (non représentés) aptes à fournir une ou plusieurs mesures $T_{BAT}$ de la température de la batterie.

Typiquement, l'unité de contrôle électronique ECU recueille donc la mesure de courant $I_{BAT}$, la mesure de température $T_{BAT}$ de la batterie, et donc la tension de cellule minimale $U_{Cmin}$ et la tension de cellule maximale $U_{Cmax}$. L'unité de contrôle électronique ECU calcule au moyen d'un deuxième module 20 d'estimation l'état de charge minimale $SOC_{min}$ de la cellule à partir de la tension de cellule minimale $U_{Cmin}$, de la mesure de courant $I_{BAT}$ et de la mesure de température $T_{BAT}$ de la batterie. Un troisième module 30 d'estimation calcule l'état de charge maximale $SOC_{max}$ de la cellule à partir de la tension de cellule maximale $U_{Cmax}$, la mesure de courant $I_{BAT}$ et de la mesure de température $T_{BAT}$ de la batterie. Ces deuxième et troisième modules d'estimation 20,30 calculent des estimations de l'état de charge de la cellule respectivement $SOC_{min}$, $SOC_{max}$ à partir des trois valeurs. L'estimation de l'état de charge maximale $SOC_{max}$ et l'état charge minimale $SOC_{min}$ se fait typiquement par intégration du courant $I_{BAT}$ de la batterie, par filtrage de Kalman ou par toute autre méthode connue de l'homme du métier.

Un quatrième module 40 de calcul, préférentiellement dans l'unité de contrôle électronique ECU, reçoit des informations relatives à l'état de santé des cellules, notamment leur état de vieillissement. Les grandeurs physiques entrantes de ce quatrième module 40 de calcul sont la tension de cellule, la mesure de courant $I_{BAT}$, la mesure de température $T_{BAT}$ de la batterie, le temps de déchargement de la cellule, la capacité maximale du pack batterie, l'estimation de l'augmentation de résistance interne de la batterie, ou tout autre grandeur caractéristique du vieillissement des cellules et du pack batterie. Le calcul de la valeur minimale d'état de charge admissible $BSOC_{min}$ et de ladite valeur maximale d'état de charge admissible $BSOC_{max}$ par le quatrième module 40 peut encore être affinée en prenant en compte la température au voisinage des deux cellules identifiées, et en utilisant leur capacité maximale.

A partir d'au moins une de ces grandeurs physiques, ce quatrième module 40 ajuste la valeur minimale d'état de charge admissible $BSOC_{min}$ et ladite valeur maximale d'état de charge admissible $BSOC_{max}$ définissant la plage d'utilisation des cellules, ce qui permet de prendre en compte l'état de vieillissement de la cellule. Une telle disposition favorise la conservation d'une quantité maximale d'énergie utilisable de la batterie à un niveau sensiblement constant.

Dans un mode de réalisation, la plage d'utilisation définie entre la valeur minimale d'état de charge admissible $BSOC_{min}$ et la valeur maximale d'état de charge admissible $BSOC_{max}$ est agencée de sorte à s'élargir en fonction de l'état de santé de la cellule et de l'avancement de son vieillissement. Dans un autre mode de réalisation, ladite plage d'utilisation est agencée de sorte à être bornée lorsque la température de la batterie est relativement basse et inférieure à un seuil de température prédéterminée, dépendant des caractéristiques de performance et/ou vieillissement à froid des cellules électrochimiques constituant la batterie, par exemple 0°C. C'est le quatrième module 40 qui traite ces informations pour modifier la plage d'utilisation.

Un cinquième module 50 d'estimation, dans l'unité de contrôle électronique ECU, reçoit d'une part, les estimations de l'état de charge minimale $SOC_{min}$ et de l'état de charge maximale $SOC_{max}$ issues desdits deuxième et troisième module d'estimation 20,30, et d'autre part la valeur minimale d'état de charge admissible $BSOC_{min}$ et la valeur maximale d'état de charge admissible $BSOC_{max}$, et calcule une estimation de l'état de charge de la batterie $SOC_{pack}$ à partir de ces valeurs. Une fonction de ce cinquième module 50 d'estimation est de pondérer les valeurs $SOC_{min}$, $SOC_{max}$ en fonction des signaux $BSOC_{min}$ et $BSOC_{max}$ (qui définissent la plage d'utilisation en SOC de chacune des cellules), afin de donner plus de poids à l'information $SOC_{max}$ lorsqu'une cellule s'approche de la valeur maximale $BSOC_{max}$, et, dans le cas inverse, de donner plus de poids à l'information $SOC_{min}$ lorsqu'une cellule s'approche de la valeur minimale $BSOC_{min}$. Entre ces deux cas extrêmes, l'état de charge $SOC_{pack}$ de la batterie doit avoir un comportement continu, sans modifications abruptes de sa valeur, et borné par les valeurs $SOC_{min}$ et $SOC_{max}$ des cellules. Au-delà de la plage d'utilisation nominale, c'est-à-dire lorsque la cellule la moins chargée atteint un état de charge SOC inférieur à $BSOC_{min}$ ou lorsque la cellule la plus chargée atteint un état SOC supérieur à $BSOC_{max}$, l'état de charge $SOC_{pack}$ de la batterie doit suivre la variation de la cellule la plus limitante (c'est-à-dire $SOC_{min}$ ou $SOC_{max}$ respectivement).

Pour arriver à ce résultat, le cinquième module 50 met en oeuvre un algorithme.

Selon plusieurs cas :

- Si $SOC_{min} \geq BSOC_{min}$ et $SOC_{max} \leq BSOC_{max}$, alors est appliquée la formule suivante :

$$SOC_{pack}(k) = \frac{SOC_{min}(k) - BSOC_{min}(k)}{(BSOC_{max}(k) - SOC_{max}(k)) + (SOC_{min}(k) - BSOC_{min}(k))} \times (BSOC_{max}(k) - BSOC_{min}(k)) + BSOC_{min}(k)$$

dans laquelle $SOC_{min}$, $SOC_{max}$, $BSOC_{min}$ et $BSOC_{max}$ sont respectivement des valeurs échantillonnées, à l'instant discret k, de l'état de charge minimale, de l'état de charge maximale, de la valeur minimale d'état de charge admissible $BSOC_{min}$ et de la valeur maximale d'état de charge admissible $BSOC_{max}$.

- Si $SOC_{min} < BSOC_{min}$ et $SOC_{max} \leq BSOC_{max}$, alors est appliquée la relation suivante :

$$SOC_{pack}(k) = SOC_{min}(k)$$

- Si $SOC_{min} \geq BSOC_{min}$ et $SOC_{max} > BSOC_{max}$, alors est appliquée la relation suivante :

$$SOC_{pack}(k) = SOC_{max}(k)$$

- Si $SOC_{min} < BSOC_{min}$ et $SOC_{max} > BSOC_{max}$, alors l'état de charge $SOC_{pack}$ de la batterie est considéré comme indisponible. La batterie est dite en déséquilibre car la cellule la plus chargée a dépassé la valeur maximale d'état de charge admissible $BSOC_{max}$ tandis que la moins chargée est inférieure à la valeur minimale d'état de charge admissible $BSOC_{min}$. Une telle batterie est de fait inutilisable, et nécessite a minima un rééquilibrage.

L'utilisation d'un tel algorithme d'estimation de l'état de charge $SOC_{pack}$ de la batterie permet d'obtenir les comportements décrits sur les figure 4 et figure 5, pour deux valeurs différentes de $BSOC_{min}$ et $BSOC_{max}$: le $SOC_{pack}$ varie continûment entre $SOC_{min}$ et $SOC_{max}$, et tend vers la valeur $SOC_{min}$ quand celle-ci approche de $BSOC_{min}$, et vers $SOC_{max}$ quand celle-ci approche de $BSOC_{max}$. Au-delà de la zone nominale, $SOC_{pack}$ est égal soit à $SOC_{min}$ (quand $SOC_{min} < BSOC_{min}$) soit à $SOC_{max}$ (quand $SOC_{max} > BSOC_{max}$).

Sur la figure 4, est représenté le résultat d'estimation de l'état de charge $SOC_{pack}$ de la batterie dans une plage d'utilisation comprise entre une valeur $BSOC_{min}$ égale à 0,2 et une valeur $BSOC_{max}$ égale à 0,8. On constate avec la méthode et/ou le système d'estimation selon l'invention que l'état de charge $SOC_{pack}$ de la batterie suit l'état de charge minimale $SOC_{min}$ pour des valeurs inférieures ou égales à 0,2 et l'état de charge maximale $SOC_{max}$ pour des valeurs supérieures ou égales à 0,8. L'état de charge $SOC_{pack}$ de la batterie s'adapte automatiquement à la plage d'utilisation qui peut être modifiée en fonction de l'état de santé des cellules.

Sur la figure 5, est représenté un résultat d'estimation de l'état de charge $SOC_{pack}$ de la batterie comparable sur une plage comprise entre une valeur $BSOC_{min}$ égale à 0,3 et une valeur $BSOC_{max}$ égale à 0,7. Le comportement l'état de charge $SOC_{pack}$ de la batterie est conforme à celui attendu, l'estimation s'adaptant automatiquement à la plage d'utilisation modifiée.

En comparant avec des méthodes de l'art antérieur dont les résultats sont représentés sur les figures 2 et 3, l'estimation de l'état de charge SOC$_{pack}$ de la batterie n'est ici pas satisfaisante. En effet, lorsque l'état de charge de la batterie SOC$_{min}$ de la cellule la moins chargée atteint 0,2 (soit la valeur minimale d'état de charge admissible BSOC$_{min}$), l'état de charge SOC$_{pack}$ de la batterie est strictement supérieur à 0,2. De même, lorsque l'état de charge de la batterie SOC$_{max}$ de la cellule la plus chargée atteint 0,8, l'état de charge SOC$_{pack}$ de la batterie est strictement inférieur à 0,8. Dans cette méthode de l'art antérieur, il n'est pas tenu compte de ces plages d'utilisation. Il en résulte que cette méthode ne prend pas en compte l'état de santé des cellules et de l'évolution de leur état de vieillissement au cours du temps.

**Revendications**

1. Méthode d'estimation d'un état de charge (SOC$_{pack}$) d'une batterie comportant plusieurs cellules (C$_1$,...C$_N$) électro-chimiques connectées en série, chacune des cellules (C$_1$,...C$_N$) présentant un état de charge (SOC) maintenu entre une valeur minimale d'état de charge admissible (BSOC$_{min}$) et une valeur maximale d'état de charge admissible (BSOC$_{max}$), ladite méthode comportant les étapes suivantes :

   - une étape de détermination à un instant donné de la tension de cellule minimale (U$_{Cmin}$) et de la tension de cellule maximale (U$_{Cmax}$) parmi les tensions aux bornes des cellules,
   - une étape de calcul d'un état de charge minimale (SOC$_{min}$) de la cellule ayant la tension de cellule minimale (U$_{Cmin}$) et d'un état de charge maximale (SOC$_{max}$) de la cellule ayant la tension de cellule maximale (U$_{Cmax}$), l'état de charge (SOC$_{pack}$) de la batterie étant compris entre ledit état de charge minimale (SOC$_{min}$) et ledit état de charge maximale (SOC$_{max}$),
   la méthode en outre comportant une étape d'ajustement de ladite valeur minimale d'état de charge admissible (BSOC$_{min}$) et de ladite valeur maximale d'état de charge admissible (BSOC$_{max}$) de chaque cellule en fonction d'au moins une grandeur physique représentative d'un état de santé de la cellule et/ou en fonction de la température de la batterie et

   - ajuster l'état de charge (SOC$_{pack}$) de la batterie à la valeur d'état de charge minimale (SOC$_{min}$) lorsque l'état de charge minimale (SOC$_{min}$) de la cellule ayant la tension de cellule minimale (U$_{Cmin}$) est strictement inférieur à la valeur minimale d'état de charge admissible (BSOC$_{min}$) de ladite cellule, et,

   ajuster l'état de charge (SOC$_{pack}$) de la batterie à la valeur d'état de charge maximale (SOC$_{max}$) lorsque l'état de charge maximale (SOC$_{max}$) de la cellule ayant la tension de cellule maximale (U$_{Cmax}$) est strictement supérieur à la valeur maximale d'état de charge admissible (BSOC$_{max}$) de ladite cellule.

2. Méthode d'estimation selon la revendication précédente, **caractérisée en ce que**, lorsque l'état de charge maximale (SOC$_{max}$) de la cellule ayant la tension de cellule maximale (U$_{Cmax}$) est inférieur ou égal à la valeur maximale d'état de charge admissible (BSOC$_{max}$) de ladite cellule et que l'état de charge minimale SOC$_{min}$ de la cellule ayant la tension de cellule minimale (U$_{Cmin}$) est supérieur ou égal à la valeur minimale d'état de charge admissible (BSOC$_{min}$) de ladite cellule, la méthode d'estimation comprend une étape incluant d'estimer l'état de charge (SOC$_{pack}$) de la batterie, à un instant k donné, au moyen de la relation :

$$SOC_{pack}(k) = \frac{SOC_{min}(k) - BSOC_{\min}(k)}{(BSOC_{\max}(k) - SOC_{\max}(k)) + (SOC_{min}(k) - BSOC_{min}(k))} \times (BSOC_{\max}(k) - BSOC_{\min}(k)) + BSOC_{\min}(k)$$

3. Méthode d'estimation selon l'une quelconque des revendications précédentes **caractérisée en ce que**, lorsque l'état de charge maximale (SOC$_{max}$) de la cellule ayant la tension de cellule maximale (U$_{Cmax}$) est strictement supérieur à la valeur maximale d'état de charge admissible (BSOC$_{max}$) de ladite cellule et que l'état de charge minimale (SOC$_{min}$) de la cellule ayant la tension de cellule minimale (U$_{Cmin}$) est strictement inférieur à la valeur minimale d'état de charge admissible (BSOC$_{min}$) de ladite cellule, la méthode comprend une étape incluant d'attribuer la valeur « indisponible » à l'état de charge (SOC$_{pack}$) de la batterie.

4. Méthode d'estimation selon l'une quelconque des revendications précédentes **caractérisée en ce que** ladite au moins une grandeur physique représentative d'un état de santé de la cellule est une tension mesurée aux bornes de cette cellule et/ou un courant (I$_{BAT}$) traversant la cellule et/ou une température liée à la cellule.

5. Méthode d'estimation selon l'une quelconque des revendications précédentes, **caractérisée en ce que** la correspondance entre les valeurs minimale et maximale d'état de charge admissible ($BSOC_{min}$, $BSOC_{max}$) et ladite au moins une grandeur physique représentative de l'état de santé de la cellule est prédéterminée, préférentiellement dans une table de valeur.

6. Méthode d'estimation selon l'une quelconque des revendications précédentes, **caractérisée en ce que** :

- la plage d'utilisation définie entre la valeur minimale d'état de charge admissible ($BSOC_{min}$) et la valeur maximale d'état de charge admissible ($BSOC_{max}$) est agencée de sorte à s'élargir en fonction de l'état de santé de la cellule et de l'avancement de son vieillissement, et/ou,
- ladite plage d'utilisation est agencée de sorte à être bornée lorsque la température de la batterie est relativement basse et inférieure à un seuil de température prédéterminée

7. Système d'estimation d'un état de charge ($SOC_{pack}$) d'une batterie comportant plusieurs cellules ($C_1,...C_N$) électro-chimiques connectées en série, chacune des cellules ($C_1,...C_N$) présentant un état de charge ($SOC$) à maintenir entre une valeur minimale d'état de charge admissible ($BSOC_{min}$) et une valeur maximale d'état de charge admissible ($BSOC_{max}$), ledit système comprenant :

- un capteur de courant configuré pour fournir une mesure ($I_{BAT}$) du courant de la batterie,
- un ou plusieurs capteurs de température configurés pour fournir une mesure ($T_{BAT}$) de la température de la batterie,
- une unité de contrôle électronique (ECU) configuré pour recueillir la tension de cellule minimale ($U_{Cmin}$) et la tension de cellule maximale ($U_{Cmax}$) parmi les tensions aux bornes des cellules, l'unité de contrôle électronique (ECU) comprenant un deuxième module (20) d'estimation configuré pour estimer l'état de charge minimale ($SOC_{min}$) de la cellule au moyen de la tension de cellule minimale ($U_{Cmin}$), de la mesure de courant ($I_{BAT}$) et de la mesure de température ($T_{BAT}$) de la batterie, un troisième module (30) d'estimation configuré pour estimer l'état de charge maximale ($SOC_{max}$) de la cellule au moyen de la tension de cellule maximale ($U_{Cmax}$), de la mesure de courant ($I_{BAT}$) et de la mesure de température ($T_{BAT}$) de la batterie, un cinquième module (50) d'estimation configuré pour déterminer l'état de charge ($SOC_{pack}$) en fonction de l'état de charge minimale ($SOC_{min}$) et de l'état de charge maximale ($SOC_{max}$), et en fonction de la valeur minimale d'état de charge admissible ($BSOC_{min}$) et de la valeur maximale d'état de charge admissible ($BSOC_{max}$) déterminées par un quatrième module (40) configuré pour ajuster ladite valeur minimale d'état de charge admissible ($BSOC_{min}$) et ladite valeur maximale d'état de charge admissible ($BSOC_{max}$) de chaque cellule en fonction d'au moins une grandeur physique représentative d'un état de santé de la cellule et/ou en fonction de la température de la batterie, et dans lequel le cinquième module (50) est configuré pour ajuster l'état de charge de la batterie ($SOC_{pack}$) à la valeur d'état de charge minimale ($SOC_{min}$) lorsque l'état de charge minimale ($SOC_{min}$) de la cellule ayant la tension de cellule minimale ($U_{Cmin}$) est strictement inférieur à la valeur minimale d'état de charge admissible ($BSOC_{min}$) de ladite cellule, et, ajuster l'état de charge de la batterie ($SOC_{pack}$) à la valeur d'état de charge maximale ($SOC_{max}$) lorsque l'état de charge maximale ($SOC_{max}$) de la cellule ayant la tension de cellule maximale ($U_{Cmax}$) est strictement supérieur à la valeur maximale d'état de charge admissible ($BSOC_{max}$) de ladite cellule.

8. Système d'estimation selon la revendication 7, **caractérisé en ce qu'**il comprend un premier module (10) configuré pour délivrer directement à l'unité de contrôle électronique (ECU) uniquement la tension de cellule minimale ($U_{Cmin}$) et la tension de cellule maximale ($U_{Cmax}$) .

9. Véhicule **caractérisé en ce qu'**il comprend un système d'estimation selon l'une quelconque des revendications 7 ou 8.

**Patentansprüche**

1. Schätzverfahren eines Ladezustands ($SOC_{pack}$) einer Batterie, die mehrere in Reihe geschaltete elektrochemische Zellen ($C_1, ... C_N$) aufweist, wobei jede der Zellen ($C_1, ... C_N$) einen Ladezustand ($SOC$) aufweist, der zwischen einem zulässigen minimalen Ladezustandswert ($BSOC_{min}$) und einem zulässigen maximalen Ladezustandswert ($BSOC_{max}$) gehalten wird, wobei das Verfahren die folgenden Schritte aufweist:

- einen Schritt der Bestimmung, zu einem gegebenen Zeitpunkt, der minimalen Zellenspannung ($U_{Cmin}$) und der maximalen Zellenspannung ($U_{Cmax}$) unter den Spannungen an den Anschlüssen der Zellen,

- einen Schritt der Berechnung eines minimalen Ladezustands ($SOC_{min}$) der Zelle mit der minimalen Zellenspannung ($U_{Cmin}$) und eines maximalen Ladezustands ($SOC_{max}$) der Zelle mit der maximalen Zellenspannung ($U_{Cmax}$), wobei der Ladezustand ($SOC_{pack}$) der Batterie zwischen dem minimalen Ladezustand ($SOC_{min}$) und dem maximalen Ladezustand ($SOC_{max}$) liegt,

wobei das Verfahren außerdem einen Schritt der Anpassung des zulässigen minimalen Ladezustandswerts ($BSOC_{min}$) und des zulässigen maximalen Ladezustandswerts ($BSOC_{max}$) jeder Zelle abhängig von mindestens einer für einen Gesundheitszustand der Zelle repräsentativen physikalischen Größe und/oder abhängig von der Temperatur der Batterie aufweist, und

- Anpassen des Ladezustands ($SOC_{pack}$) der Batterie an den minimalen Ladezustandswert ($SOC_{min}$), wenn der minimale Ladezustand ($SOC_{min}$) der Zelle mit der minimalen Zellenspannung ($U_{Cmin}$) strikt niedriger ist als der zulässige minimale Ladezustandswert ($BSOC_{min}$) der Zelle, und
- Anpassen des Ladezustands ($SOC_{pack}$) der Batterie an den maximalen Ladezustandswert ($SOC_{max}$), wenn der maximale Ladezustand ($SOC_{max}$) der Zelle mit der maximalen Zellenspannung ($U_{Cmax}$) strikt höher ist als der zulässige maximale Ladezustandswert ($BSOC_{max}$) der Zelle.

2. Schätzverfahren nach dem vorhergehenden Anspruch, **dadurch gekennzeichnet, dass**, wenn der maximale Ladezustand ($SOC_{max}$) der Zelle mit der maximalen Zellenspannung ($U_{Cmax}$) niedriger als der oder gleich dem zulässigen maximalen Ladezustandswert ($BSOC_{max}$) der Zelle ist, und der minimale Ladezustand ($SOC_{min}$) der Zelle mit der minimalen Zellenspannung ($U_{Cmin}$) höher als der oder gleich dem zulässigen minimalen Ladezustandswert ($BSOC_{min}$) der Zelle ist, das Schätzverfahren einen Schritt enthält, der das Schätzen des Ladezustands ($SOC_{pack}$) der Batterie zu einem gegebenen Zeitpunkt k mittels der Beziehung umfasst:

$$SOC_{pack}(k) = \frac{SOC_{min}(k) - BSOC_{min}(k)}{\left(BSOC_{max}(k) - SOC_{max}(k)\right) + \left(SOC_{min}(k) - BSOC_{min}(k)\right)}$$
$$\times \left(BSOC_{max}(k) - BSOC_{min}(k)\right) + BSOC_{min}(k)$$

3. Schätzverfahren nach einem der vorhergehenden Ansprüche, **dadurch gekennzeichnet, dass**, wenn der maximale Ladezustand ($SOC_{max}$) der Zelle mit der maximalen Zellenspannung ($U_{Cmax}$) strikt höher ist als der zulässige maximale Ladezustandswert ($BSOC_{max}$) der Zelle, und wenn der minimale Ladezustand ($SOC_{min}$) der Zelle mit der minimalen Zellenspannung ($U_{Cmin}$) strikt niedriger ist als der zulässige minimale Ladezustandswert ($BSOC_{min}$) der Zelle, das Verfahren einen Schritt enthält, der die Zuweisung des Werts "nicht verfügbar" zum Ladezustand ($SOC_{pack}$) der Batterie umfasst.

4. Schätzverfahren nach einem der vorhergehenden Ansprüche, **dadurch gekennzeichnet, dass** die für einen Gesundheitszustand der Zelle repräsentative mindestens eine physikalische Größe eine an den Anschlüssen dieser Zelle gemessene Spannung und/oder ein die Zelle durchquerender Strom ($I_{BAT}$) und/oder eine mit der Zelle verbundene Temperatur ist.

5. Schätzverfahren nach einem der vorhergehenden Ansprüche, **dadurch gekennzeichnet, dass** die Entsprechung zwischen den zulässigen minimalen und maximalen Ladezustandswerten ($BSOC_{min}$, $BSOC_{max}$) und der für den Gesundheitszustand der Zelle repräsentativen mindestens einen physikalischen Größe vorbestimmt ist, vorzugsweise in einer Wertetabelle.

6. Schätzverfahren nach einem der vorhergehenden Ansprüche, **dadurch gekennzeichnet, dass**:

- der zwischen dem zulässigen minimalen Ladezustandswert ($BSOC_{min}$) und dem zulässigen maximalen Ladezustandswert ($BSOC_{max}$) definierte Nutzungsbereich so eingerichtet ist, dass er sich abhängig vom Gesundheitszustand der Zelle und vom Fortschreiten ihrer Alterung vergrößert, und/oder
- der Nutzungsbereich so eingerichtet ist, dass er begrenzt ist, wenn die Temperatur der Batterie relativ niedrig und unterhalb einer vorbestimmten Temperaturschwelle ist.

7. Schätzsystem eines Ladezustands ($SOC_{pack}$) einer Batterie, die mehrere in Reihe geschaltete elektrochemische Zellen ($C_1, ... C_N$) aufweist, wobei jede der Zellen ($C_1, ... C_N$) einen Ladezustand ($SOC$) aufweist, der zwischen einem zulässigen minimalen Ladezustandswert ($BSOC_{min}$) und einem zulässigen maximalen Ladezustandswert

(BSOC$_{max}$) zu halten ist, wobei das System enthält:

- einen Stromabnehmer, der konfiguriert ist, eine Messung (I$_{BAT}$) des Stroms der Batterie zu liefern,
- einen oder mehrere Temperaturfühler, die konfiguriert sind, eine Messung (T$_{BAT}$) der Temperatur der Batterie zu liefern,
- eine elektronische Steuereinheit (ECU), die konfiguriert ist, die minimale Zellenspannung (U$_{Cmin}$) und die maximale Zellenspannung (U$_{Cmax}$) unter den Spannungen an den Anschlüssen der Zellen zu entnehmen, wobei die elektronische Steuereinheit (ECU) ein zweites Schätzmodul (20), das konfiguriert ist, den minimalen Ladezustand (SOC$_{min}$) der Zelle mittels der minimalen Zellenspannung (U$_{Cmin}$), der Strommessung (I$_{BAT}$) und der Temperaturmessung (T$_{BAT}$) der Batterie zu schätzen, ein drittes Schätzmodul (30), das konfiguriert ist, den maximalen Ladezustand (SOC$_{max}$) der Zelle mittels der maximalen Zellenspannung (U$_{Cmax}$), der Strommessung (I$_{BAT}$) und der Temperaturmessung (T$_{BAT}$) der Batterie zu schätzen, ein fünftes Schätzmodul (50) enthält, das konfiguriert ist, den Ladezustand (SOC$_{pack}$) abhängig vom minimalen Ladezustand (SOC$_{min}$) und vom maximalen Ladezustand (SOC$_{max}$) und abhängig vom zulässigen minimalen Ladezustandswert (BSOC$_{min}$) und vom zulässigen maximalen Ladezustandswert (BSOC$_{max}$) zu bestimmen, die von einem vierten Modul (40) bestimmt werden, das konfiguriert ist, den zulässigen minimalen Ladezustandswert (BSOC$_{min}$) und den zulässigen maximalen Ladezustandswert (BSOC$_{max}$) jeder Zelle abhängig von mindestens einer für einen Gesundheitszustand der Zelle repräsentativen physikalischen Größe und/oder abhängig von der Temperatur der Batterie anzupassen, und wobei das fünfte Modul (50) konfiguriert ist, den Ladezustand der Batterie (SOC$_{pack}$) an den minimalen Ladezustandswert (SOC$_{min}$) anzupassen, wenn der minimale Ladezustand (SOC$_{min}$) der Zelle mit der minimalen Zellenspannung (U$_{Cmin}$) strikt niedriger ist als der zulässige minimale Ladezustandswert (BSOC$_{min}$) der Zelle, und den Ladezustand der Batterie (SOC$_{pack}$) an den maximalen Ladezustandswert (SOC$_{max}$) anzupassen, wenn der maximale Ladezustand (SOC$_{max}$) der Zelle mit der maximalen Zellenspannung (U$_{Cmax}$) strikt höher ist als der zulässige maximale Ladezustandswert (BSOC$_{max}$) der Zelle.

8. Schätzsystem nach Anspruch 7, **dadurch gekennzeichnet, dass** es ein erstes Modul (10) enthält, das konfiguriert ist, nur die minimale Zellenspannung (U$_{Cmin}$) und die maximale Zellenspannung (U$_{Cmax}$) direkt an die elektronische Steuereinheit (ECU) zu liefern.

9. Fahrzeug, **dadurch gekennzeichnet, dass** es ein Schätzsystem nach einem der Ansprüche 7 oder 8 enthält.

**Claims**

1. Method for estimating a state of charge (SOC$_{pack}$) of a battery comprising several electrochemical cells (C$_1$, ... C$_N$) connected in series, each of the cells (C$_1$, ... C$_N$) having a state of charge (SOC) which is kept between a minimum allowable state of charge value (BSOC$_{min}$) and a maximum allowable state of charge value (BSOC$_{max}$), said method comprising the following steps:

    - a step of determining, at a given instant, the minimum cell voltage (U$_{Cmin}$) and the maximum cell voltage (U$_{Cmax}$) from among the voltages at the terminals of the cells,
    - a step of calculating a minimum state of charge (SOC$_{min}$) of the cell having the minimum cell voltage (U$_{Cmin}$) and a maximum state of charge (SOC$_{max}$) of the cell having the maximum cell voltage (U$_{Cmax}$), the state of charge (SOC$_{pack}$) of the battery being between said minimum state of charge (SOC$_{min}$) and said maximum state of charge (SOC$_{max}$),

    the method further comprising a step of adjusting said minimum allowable state of charge value (BSOC$_{min}$) and said maximum allowable state of charge value (BSOC$_{max}$) of each cell depending on at least one physical quantity which is representative of a state of health of the cell and/or depending on the temperature of the battery, and

    - adjusting the state of charge (SOC$_{pack}$) of the battery to the minimum state of charge value (SOC$_{min}$) when the minimum state of charge (SOC$_{min}$) of the cell having the minimum cell voltage (U$_{Cmin}$) is strictly less than the minimum allowable state of charge value (BSOC$_{min}$) of said cell, and
    - adjusting the state of charge (SOC$_{pack}$) of the battery to the maximum state of charge value (SOC$_{max}$) when the maximum state of charge (SOC$_{max}$) of the cell having the maximum cell voltage (U$_{Cmax}$) is strictly greater than the maximum allowable state of charge value (BSOC$_{max}$) of said cell.

2. Estimation method according to the preceding claim, **characterized in that**, when the maximum state of charge

(SOC$_{max}$) of the cell having the maximum cell voltage (U$_{Cmax}$) is less than or equal to the maximum allowable state of charge value (BSOC$_{max}$) of said cell and the minimum state of charge (SOC$_{min}$) of the cell having the minimum cell voltage (U$_{Cmin}$) is greater than or equal to the minimum allowable state of charge value (BSOC$_{min}$) of said cell, the estimation method comprises a step including estimating the state of charge (SOC$_{pack}$) of the battery, at a given instant k, by means of the relationship:

$$SOC_{pack}(k) = \frac{SOC_{min}(k) - BSOC_{min}(k)}{(BSOC_{max}(k) - SOC_{max}(k)) + (SOC_{min}(k) - BSOC_{min}(k))} \times \left(BSOC_{max}(k) - BSOC_{min}(k)\right) + BSOC_{min}(k)$$

3.  Estimation method according to either one of the preceding claims, **characterized in that**, when the maximum state of charge (SOC$_{max}$) of the cell having the maximum cell voltage (U$_{Cmax}$) is strictly greater than the maximum allowable state of charge value (BSOC$_{max}$) of said cell and the minimum state of charge (SOC$_{min}$) of the cell having the minimum cell voltage (U$_{Cmin}$) is strictly less than the minimum allowable state of charge value (BSOC$_{min}$) of said cell, the method comprises a step including attributing the value "unavailable" to the state of charge (SOC$_{pack}$) of the battery.

4.  Estimation method according to any one of the preceding claims, **characterized in that** said at least one physical quantity which is representative of a state of health of the cell is a voltage measured at the terminals of this cell and/or a current (I$_{BAT}$) flowing through the cell and/or a temperature associated with the cell.

5.  Estimation method according to any one of the preceding claims, **characterized in that** the correspondence between the minimum and maximum allowable state of charge values (BSOC$_{min}$, BSOC$_{max}$) and said at least one physical quantity which is representative of the state of health of the cell is predetermined, preferably in a value table.

6.  Estimation method according to any one of the preceding claims, **characterized in that**:

    - the range of use defined between the minimum allowable state of charge value (BSOC$_{min}$) and the maximum allowable state of charge value (BSOC$_{max}$) is arranged so as to widen depending on the state of health of the cell and on the progress of its ageing, and/or
    - said range of use is arranged so as to be limited when the temperature of the battery is relatively low and below a predetermined temperature threshold.

7.  System for estimating a state of charge (SOC$_{pack}$) of a battery comprising several electrochemical cells (C$_1$, ... C$_N$) connected in series, each of the cells (C$_1$, ... C$_N$) having a state of charge (SOC) to be kept between a minimum allowable state of charge value (BSOC$_{min}$) and a maximum allowable state of charge value (BSOC$_{max}$), said system comprising:

    - a current sensor configured to provide a measurement (I$_{BAT}$) of the current of the battery,
    - one or more temperature sensors configured to provide a measurement (T$_{BAT}$) of the temperature of the battery,
    - an electronic control unit (ECU) configured to collect the minimum cell voltage (U$_{Cmin}$) and the maximum cell voltage (U$_{Cmax}$) from among the voltages at the terminals of the cells, the electronic control unit (ECU) comprising a second estimation module (20) configured to estimate the minimum state of charge (SOC$_{min}$) of the cell by means of the minimum cell voltage (U$_{Cmin}$), of the current measurement (I$_{BAT}$) and of the temperature measurement (T$_{BAT}$) of the battery, a third estimation module (30) configured to estimate the maximum state of charge (SOC$_{max}$) of the cell by means of the maximum cell voltage (U$_{Cmax}$), of the current measurement (I$_{BAT}$) and of the temperature measurement (T$_{BAT}$) of the battery, a fifth estimation module (50) configured to determine the state of charge (SOC$_{pack}$) depending on the minimum state of charge (SOC$_{min}$) and on the maximum state of charge (SOC$_{max}$), and depending on the minimum allowable state of charge value (BSOC$_{min}$) and on the maximum allowable state of charge value (BSOC$_{max}$) which are determined by a fourth module (40) configured to adjust said minimum allowable state of charge value (BSOC$_{min}$) and said maximum allowable state of charge value (BSOC$_{max}$) of each cell depending on at least one physical quantity which is representative of a state of health of the cell and/or depending on the temperature of the battery,

    and wherein the fifth module (50) is configured to adjust the state of charge of the battery (SOC$_{pack}$) to the minimum state of charge value (SOC$_{min}$) when the minimum state of charge (SOC$_{min}$) of the cell having the minimum cell voltage (U$_{Cmin}$) is strictly less than the minimum allowable state of charge value (BSOC$_{min}$) of said cell, and adjusting the state of charge of the battery ($SOC_{pack}$) to the maximum state of charge value ($SOC_{max}$) when the maximum state of charge ($SOC_{max}$) of the cell having the maximum cell voltage ($U_{Cmax}$) is strictly greater than the maximum allowable state of charge value ($BSOC_{max}$) of said cell.

8. Estimation system according to Claim 7, **characterized in that** it comprises a first module (10) configured to deliver, directly to the electronic control unit (ECU), only the minimum cell voltage ($U_{Cmin}$) and the maximum cell voltage ($U_{Cmax}$) .

9. Vehicle, **characterized in that** it comprises an estimation system according to either one of Claims 7 and 8.

Figure 1

Figure 2

Figure 3

Figure 4

Figure 5

Figure 6

## RÉFÉRENCES CITÉES DANS LA DESCRIPTION

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Documents brevets cités dans la description**

- FR 2990516
- JP 2012173250 A
- EP 2473833 A1
- WO 2013167833 A1
- US 2913027048 A1
- WO 2011079977 A2
- WO 20050105339 A1
- FR 2982676 A1
- US 2013154574 A1
- DE 1020090421994 A1
- EP 2572951 A1
- WO 2012169009 A1